# EUROPÄISCHE PATENTSCHRIFT

(11) **EP 1 929 552 B1**
(45) Veröffentlichungstag und Bekanntmachung des Hinweises auf die Patenterteilung: **04.11.2009**
(21) Anmeldenummer: 06849368.3
(22) Anmeldetag: 14.09.2006
(51) Int. Cl.: H01L 33/00, H01L 31/0224, H01S 5/042, H01L 31/18, H01L 31/103

(54) **OPTOELEKTRONISCHES HALBLEITERBAUELEMENT MIT STROMAUFWEITUNGSSCHICHT**
OPTOELECTRONIC SEMICONDUCTOR COMPONENT WITH CURRENT SPREADING LAYER
ÉLÉMENT SEMI-CONDUCTEUR OPTOÉLECTRONIQUE DOTÉ D'UNE COUCHE D'ÉTALEMENT DU COURANT

(30) Priorität: 27.09.2005 DE 102005046190
(43) Veröffentlichungstag der Anmeldung: 11.06.2008
(73) Patentinhaber: OSRAM Opto Semiconductors GmbH, 93055 Regensburg (DE)
(72) Erfinder: AHLSTEDT, Magnus, 93049 Regensburg (DE); EISSLER, Dieter, 93152 Nittendorf (DE); WALTER, Robert, 92331 Parsberg (DE); WIRTH, Ralf, 93186 Pettendorf-Adlersberg (DE)
(74) Vertreter: Epping - Hermann - Fischer
(86) Internationale Anmeldenummer: PCT/DE2006/001617
(87) Internationale Veröffentlichungsnummer: WO 2007/087769

(56) Entgegenhaltungen:
- WO-A-2005/024961
- DE-A1- 10 346 606
- JP-A- 2004 146 539
- US-A- 5 760 423
- US-A- 5 861 636

## Beschreibung

Es wird ein optoelektronisches Halbleiterbauelement angegeben.

Die Druckschrift EP 1 523 047 A2 beschreibt ein optoelektronisches Halbleiterbauelement.

Die Druckschrift US 5,760,423 beschreibt ein optoelektronisches Halbleiterbauelement nach dem Oberbegriff des Patentanspruch 1.

Eine zu lösende Aufgabe besteht darin, ein optoelektronisches Halbleiterbauelement anzugeben, das eine elektrisch und mechanisch besonders stabile Kontaktierung aufweist. Eine weitere Aufgabe besteht darin, Verfahren zur Herstellung eines solchen optoelektronischen Halbleiterbauelements anzugeben.

Gemäß zumindest einer Ausführungsform umfasst das optoelektronische Halbleiterbauelement einen Halbleiterkörper. Der Halbleiterkörper enthält zum Beispiel eine Halbleiterschichtenfolge, die zur Strahlungserzeugung oder zur Umwandlung von elektromagnetischer Strahlung in elektrische Ladungen geeignet ist. Beispielsweise handelt es sich bei dem Halbleiterkörper um einen epitaktisch gewachsenen Halbleiterkörper.

Gemäß zumindest einer Ausführungsform des optoelektronischen Halbleiterbauelements ist auf den Halbleiterkörper zumindest stellenweise eine Stromaufweitungsschicht aufgebracht. Die Stromaufweitungsschicht zeichnet sich vorzugsweise durch eine besonders gute elektrische Querleitfähigkeit aus. Das heißt, die Stromaufweitungsschicht ist geeignet, einen in einem begrenzten Gebiet der Stromaufweitungsschicht in diese eingeprägten Strom auf eine möglichst große Fläche zu verteilen. Die Stromaufweitungsschicht ist besonders gut geeignet, den in sie eingeprägten elektrischen Strom in Richtungen parallel zu einer Hauptfläche der Stromaufweitungsschicht zu leiten.

Bevorzugt ist die Stromaufweitungsschicht zusätzlich zumindest für einen Teil der im optoelektronischen Halbleiterchip erzeugten oder vom optoelektronischen Halbleiterchip empfangenen elektromagnetischen Strahlung durchlässig. Die Transmittivität der Stromaufweitungsschicht beträgt für elektromagnetische Strahlung im sichtbaren Spektralbereich dabei vorzugsweise wenigstens 90 Prozent.

Gemäß zumindest einer Ausführungsform des optoelektronischen Halbleiterbauelements enthält die Stromaufweitungsschicht ein Metall, das in der Stromaufweitungsschicht ein transparentes, elektrisch leitfähiges Metalloxid bildet. Das heißt, die Stromaufweitungsschicht enthält zumindest stellenweise ein transparentes, elektrisch leitfähiges Metalloxid. Bevorzugt umfasst die Stromaufweitungsschicht dabei ein Material aus der Gruppe der sogenannten transparenten, leitfähigen Oxide ("transparent conductive oxide", TCO). Ferner ist es möglich, dass das Metalloxid der Stromaufweitungsschicht mit einem weiteren Material - beispielsweise einem Metall oder einem Halbleiter - n- oder p-leitend dotiert ist.

Gemäß zumindest einer Ausführungsform des optoelektronischen Halbleiterbauelements nimmt die Konzentration des Metalls, das in der Stromaufweitungsschicht ein Oxid bildet, von der dem Halbleiterkörper zugewandten Seite der Stromaufweitungsschicht zu der dem Halbleiterkörper abgewandten Seite der Stromaufweitungsschicht hin ab. Das heißt, auf der Seite der Stromaufweitungsschicht, die dem Halbleiterkörper zugewandt ist, ist die Metallkonzentration am höchsten. Zum Beispiel kann die Konzentration des Metalls dort bis zu 100 Prozent betragen. Das heißt, dort kann die Stromaufweitungsschicht einen Bereich umfassen, der aus dem Metall besteht. Mit wachsendem Abstand vom Halbleiterkörper nimmt die Konzentration des Metalls in der Stromaufweitungsschicht dann ab. Die Konzentration von Sauerstoff nimmt entsprechend zu. Zum Beispiel kann das Metalloxid der Stromaufweitungsschicht auf ihrer dem Halbleiterkörper abgewandten Seite stellenweise eine stöchiometrische Zusammensetzung aufweisen.

Gemäß zumindest einer Ausführungsform wird ein optoelektronisches Halbleiterbauelement mit einem Halbleiterkörper angegeben. Das optoelektronische Bauelement weist eine Stromaufweitungsschicht auf, die zumindest stellenweise auf den Halbleiterkörper aufgebracht ist. Die Stromaufweitungsschicht enthält ein Metall, das in der Stromaufweitungsschicht ein transparentes, elektrisch leitfähiges Metalloxid bildet und die Konzentration des Metalls nimmt von der dem Halbleiterkörper zugewandten Seite der Stromaufweitungsschicht zu der dem Halbleiterkörper abgewandten Seite hin ab.

Dabei macht sich das optoelektronische Halbleiterbauelement unter anderem die Erkenntnis zunutze, dass eine möglichst hohe Metallkonzentration an der Grenzfläche zwischen Halbleiterkörper und Stromaufweitungsschicht einen besonders guten ohmschen Kontakt zwischen Halbleiterkörper und Stromaufweitungsschicht ermöglicht. Ferner hat sich gezeigt, dass durch die erhöhte Metallkonzentration am Halbleiterkörper die Stromaufweitungsschicht besonders gut am Halbleiterkörper haftet und die Gefahr eines Ablösens der Stromaufweitungsschicht vom Halbleiterkörper dadurch reduziert ist. Weiter kann die Stromaufweitungsschicht besonders einfach hergestellt werden, wenn der metallreiche Bereich der Stromaufweitungsschicht - also der Bereich der Stromaufweitungsschicht in Nähe des Halbleiterkörpers - das Metall umfasst, das in der Stromaufweitungsschicht das Metalloxid bildet.

Gemäß zumindest einer Ausführungsform des optoelektronischen Halbleiterbauelements nimmt die Metallkonzentration in der Stromaufweitungsschicht kontinuierlich ab. Mit anderen Worten ändert sich die Metallkonzentration nicht sprunghaft in der Art, dass in einem Bereich der Stromaufweitungsschicht lediglich nicht oxidiertes Metall enthalten ist und in einem benachbarten Bereich der Stromaufweitungsschicht lediglich Metalloxid enthalten ist. Vielmehr ist der Übergang von einem metallreichen zu einem metallärmeren Bereich der Stromaufweitungsschicht fließend.

Gemäß zumindest einer Ausführungsform des optoelektronischen Halbleiterchips umfasst die Stromaufweitungsschicht stellenweise ein Metalloxid stöchiometrischer Zusammensetzung. Das heißt, es gibt Gebiete in der Stromaufweitungsschicht, in denen ein Metalloxid in stöchiometrischer Zusammensetzung vorliegt. Beispielsweise weist die Stromaufweitungsschicht in der Nähe des Halbleiterkörpers eine hohe Metallkonzentration auf. Mit wachsendem Abstand vom Halbleiterkörper kann die Metallkonzentration dann derart abfallen, dass auf der dem Halbleiterkörper abgewandten Seite der Stromaufweitungsschicht stellenweise ein Metalloxid stöchiometrischer Zusammensetzung vorliegt. Mit anderen Worten gibt es Bereiche der Stromaufweitungsschicht, in denen dort vorhandenen Metallatome jeweils an zumindest ein Sauerstoffatom gebunden sind.

Gemäß zumindest einer Ausführungsform des optoelektronischen Halbleiterbauelements weist die Stromaufweitungsschicht Oxide zumindest eines der folgenden Metalle oder Metalllegierungen auf: Indium, Zinn; Indiumzinn, Zink, Cadmium, Titan. Mögliche Oxide in der Stromaufweitungsschicht sind dann beispielsweise durch folgende Oxide gegeben: ZnO, SnO₂, In₂O₃, Zn₂SnO₄, CdSnO₃, ZnSnO₃, MgIn₂O₄, GaInO₃, Zn₂In₂O₅, In₄Sn₃O₁₂ oder Mischungen.

Ferner ist es möglich, dass die Metalloxide n- oder p-leitend dotiert sind.

Gemäß zumindest einer Ausführungsform ist die Stromaufweitungsschicht auf eine Strahlungsdurchtrittsfläche des optoelektronischen Halbleiterbauelements aufgebracht. Die Strahlungsdurchtrittsfläche ist dabei eine Fläche des optoelektronischen Halbleiterbauelements, durch die elektromagnetische Strahlung in den Halbleiterkörper eintritt oder durch die elektromagnetische Strahlung aus dem Halbleiterkörper austritt. Dabei kann es sich bei dem optoelektronischen Halbleiterbauelement beispielsweise um eines der folgenden Bauelemente handeln: Fotodiodenchip, Leuchtdiodenchip, Laserdiodenchip.

Es wird ferner ein Verfahren zur Herstellung eines optoelektronischen Bauelements angegeben. Beispielsweise kann mittels des Verfahrens ein optoelektronisches Halbleiterbauelement gemäß zumindest einer der oben beschriebenen Ausführungsformen hergestellt werden.

Gemäß zumindest einer Ausführungsform des Verfahrens zur Herstellung eines optoelektronischen Halbleiterbauelements wird zunächst eine Schicht, die ein Metall umfasst, zumindest stellenweise auf die Oberfläche eines Halbleiterkörpers aufgebracht. Beispielsweise wird die Metallschicht auf die Strahlungsdurchtrittsfläche des Halbleiterkörpers aufgebracht.

Bevorzugt beträgt die Dicke der Metallschicht zwischen wenigstens 0,2 und maximal 3,0 Nanometer. Besonders bevorzugt beträgt die Schichtdicke der Metallschicht zwischen 0,3 und 2,0 Nanometer. Die Schichtdicke ist dabei vorzugsweise so dünn gewählt, dass sie für einen Großteil der vom optoelektronischen Halbleiterbauelement im Betrieb emittierten oder vom optoelektronischen Halbleiterbauelement zu empfangenen elektromagnetischen Strahlung durchlässig ist.

Die Metallschicht enthält oder besteht bevorzugt aus einem der oben genannten Metalle. Das heißt, sie enthält oder besteht aus wenigstens einem der folgenden Metalle: Indium, Zinn, Indiumzinn, Zink, Cadmium, Titan. Ferner kann die Metallschicht auch Metalllegierungen wie beispielsweise Goldzink (AuZn) enthalten oder aus solchen Legierungen bestehen.

Gemäß zumindest einer Ausführungsform des Verfahrens zur Herstellung des optoelektronischen Halbleiterbauelements wird in einem folgenden Verfahrensschritt eine Schicht auf die Metallschicht aufgebracht, die ein Oxid eines Metalls der Metallschicht umfasst. Beispielsweise enthält oder besteht die Metalloxidschicht aus wenigstens einem der folgenden Metalloxide: ZnO, SnO₂, In₂O₃, Zn₂SnO₄, ZnSnO₃, CdSnO₃, MgIn₂O₄, GaInO₃, Zn₂In₂O₅, In₄Sn₃O₁₂.

Gemäß zumindest einer Ausführungsform des Verfahrens zur Herstellung eines optoelektronischen Halbleiterbauelements wird die auf den Halbleiterkörper aufgebrachte Schichtenfolge aus Metallschicht und Metalloxidschicht nachfolgend thermisch behandelt. Dazu wird die aufgebrachte Schichtenfolge beispielsweise auf Temperaturen zwischen 200 und 600 Grad Celsius erhitzt, bevorzugt auf Temperaturen zwischen 300 und 500 Grad Celsius. Dieser Temperaturbereich erweist sich als besonders vorteilhaft zur Herstellung einer besonders gut elektrisch leitfähigen Stormaufweitungsschicht.

Die Schichtenfolge kann zum Beispiel in einem Brennofen mit 0 bis 20% Partialdruck Sauerstoff, besonders bevorzugt 2 bis 10 % Partialdruck Sauerstoff erhitzt werden. Dieser Bereich des Partialdrucks erweist sich als besonders vorteilhaft zur Herstellung einer besonders gut elektrisch leitfähigen Stormaufweitungsschicht.

Beim Erhitzen der Schichtenfolge kann auch eine RTA (rapid thermal annealing) Technik zum Einsatz kommen. Ferner ist es möglich, dass die Schichtenfolge unter N₂, N₂/Ar oder N₂/H₂ Atmosphäre erhitzt wird.

Bevorzugt wird die Schichtfolge für Zeiten zwischen einer und fünf Minuten erhitzt. Dieser Bereich der Dauer der Erhitzung der Schichtenfolge erweist sich als besonders vorteilhaft zur Herstellung einer besonders gut elektrisch leitfähigen Stormaufweitungsschicht.

Gemäß zumindest einer Ausführungsform des Verfahrens zur Herstellung eines optoelektronischen Halbleiterbauelements wird zumindest eine Schicht umfassend ein Metall auf einen Halbleiterkörper aufgebracht. In einem nachfolgenden Verfahrensschritt wird eine Schicht umfassend ein Oxid des Metalls auf die Metallschicht aufgebracht. In einem weiteren Verfahrensschritt wird die aufgebrachte Schichtenfolge aus Metall- und Metalloxidschicht thermisch behandelt.

Das beschriebene Verfahren macht sich dabei unter anderem die Erkenntnis zunutze, dass durch das thermische Behandeln ein Durchreagieren der Metall- und der Metalloxidschicht ermöglicht wird. Dadurch kann in der Stromaufweitungsschicht ein Verlauf der Metallkonzentration erzeugt werden. Die Konzentration des Metalls in der Stromaufweitungsschicht nimmt dabei in Richtung vom Halbleiterkörper weg ab. Mittels Temperatur und Dauer der thermischen Behandlung, kann ein gewünschtes Profil der Metallkonzentration in der Stromaufweitungsschicht erzeugt werden.

Das hier beschriebene Verfahren macht sich dabei unter anderem die Idee zunutze, dass mittels der dünnen Metallschicht an der Schnittstelle zwischen Stromaufweitungsschicht und Halbleiterkörper ein mechanisch und elektrisch besonders stabiler ohmscher Kontakt zwischen Halbleiterkörper und Stromaufweitungsschicht hergestellt werden kann. Ferner kann die Metallschicht zur Dotierverbesserung der Stromaufweitungsschicht an der Schnittstelle zwischen Halbleiterkörper und Stromaufweitungsschicht dienen.

Gemäß zumindest einer Ausführungsform des Verfahrens zur Herstellung eines optoelektronischen Halbleiterbauelements wird zur Erzeugung der Stromaufweitungsschicht auf den Halbleiterkörper ein Metall aufgebracht, wobei das aufgebrachte Metall im Verlaufe des Aufbringungs- oder Beschichtungsvorgangs mit zunehmender Rate oxidiert wird. Das heißt beispielsweise, dass während des Beschichtens des Halbleiterkörpers mit einem Metall der Sauerstofffluss erhöht wird, sodass im Laufe des Beschichtens ein immer größer werdender Anteil des aufgebrachten Metalls oxidiert wird. Auf diese Weise kann eine Stromaufweitungsschicht erzeugt werden, bei der die Metallkonzentration mit wachsendem Abstand vom Halbleiterkörper abnimmt und die Sauerstoffkonzentration zunimmt. Beispielsweise kann die Beschichtung dazu mittels reaktiven Sputterns des Metalls erfolgen, wobei der Sauerstofffluss im Laufe des Beschichtungsvorgangs erhöht wird.

Dabei ist es allgemein möglich, dass die Stromaufweitungsschicht mittels eines PVD (kurz für physical vapour deposition) oder CVD (kurz für chemical vapour deposition) Verfahrens aufgebracht wird. Dabei wird die Sauerstoffkonzentration vorzugsweise während des Abscheide-Prozesses angereichert. Die Sauerstoffkonzentration in der Stromaufweitungsschicht wird dabei derart eingestellt, dass eine gut leitende Metalloxid-Schicht resultiert.

Das Verfahren macht sich dabei unter anderem die Idee zunutze, dass über die Sauerstoffzufuhr die Metallkonzentration in der wachsenden Stromaufweitungsschicht kontrolliert werden kann. Auf diese Weise kann ein vorgebbares Profil der Metallkonzentration in der Stromaufweitungsschicht eingestellt werden.

Gemäß zumindest einer Ausführungsform des Verfahrens zur Herstellung eines optoelektronischen Halbleiterbauelements wird der Sauerstofffluss während des Beschichtungsvorgangs kontinuierlich erhöht.

Im Folgenden werden das hier beschriebene optoelektronische Halbleiterbauelement sowie das hier beschriebene Verfahren zur Herstellung eines optoelektronischen Bauelements anhand von Ausführungsbeispielen und den dazugehörigen Figuren näher erläutert.

Die Figuren 1A, 1B und 1C zeigen schematische Schnittdarstellungen zur Erläuterung eines Ausführungsbeispiels des hier beschriebenen Verfahrens zur Herstellung eines optoelektronischen Halbleiterbauelements.

Die Figur 2 zeigt eine schematische Schnittdarstellung eines Ausführungsbeispiels des hier beschriebenen optoelektronischen Halbleiterbauelements.

Figur 3 zeigt schematisch den Verlauf der Metallkonzentration in der Stromaufweitungsschicht eines Ausführungsbeispiels des hier beschriebenen optoelektronischen Halbleiterbauelements.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

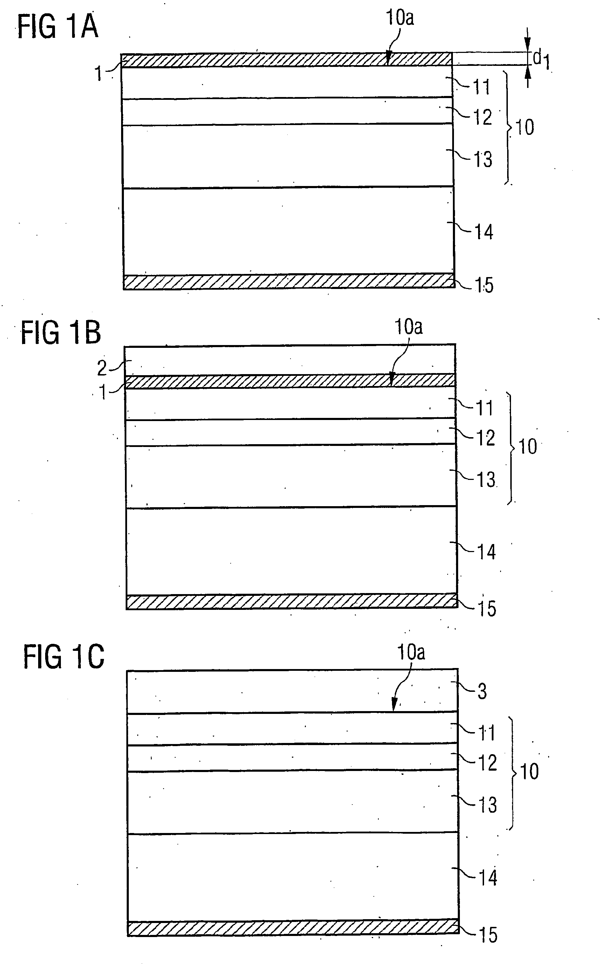

Die Figuren 1A bis 1C zeigen schematische Schnittdarstellungen zur Erläuterung eines ersten Ausführungsbeispiels des Verfahrens zur Herstellung eines optoelektronischen Halbleiterbauelements.

Figur 1A zeigt eine schematische Schnittdarstellung eines Halbleiterkörpers 10. Der Halbleiterkörper 10 umfasst eine Mantelschicht 11, die zum Beispiel p-leitend dotiert sein kann. Die Mantelschicht 11 kann dabei beispielsweise mit einem p-Dotierstoff dotiert sein. Der Halbleiterkörper 10 umfasst ferner eine aktive Zone 12, die beispielsweise eine zur Strahlungserzeugung geeignete Epitaxieschichtenfolge umfasst. Die Epitaxieschichtenfolge kann zum Beispiel einen pn-Übergang, eine Quantentopfstruktur, oder eine Mehrfachquantentopfstruktur enthalten.

Die Bezeichnung Quantentopfstruktur umfasst im Rahmen der Anmeldung auch jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Die Epitaxieschichtenfolge basiert vorzugsweise auf einem Phosphid-, Arsenid- oder einem Nitrid-Verbindungshalbleitermaterial.

"Auf Phosphid-Verbindungshalbleitern basierend" bedeutet in diesem Zusammenhang, dass ein derart bezeichnetes Bauelement oder Teil eines Bauelements vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass ein derart bezeichnetes Bauelement oder Teil eines Bauelements vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

"Auf Nitrid-Verbindungshalbleitern basierend" bedeutet im vorliegenden Zusammenhang, dass die aktive EpitaxieSchichtenfolge oder zumindest eine Schicht davon ein Nitrid-III/V-Verbinduhgshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘn-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Weiter umfasst der Halbleiterkörper 10 vorzugsweise eine Mantelschicht 13, die n-leitend sein kann. Beispielsweise ist die Mantelschicht 13 dazu mit einem n-Dotierstoff dotiert.

Der Halbleiterkörper 10 ist bevorzugt auf einem Träger 14 aufgebracht. Bei dem Träger 14 kann es sich um ein Aufwachssubstrat für die Schichten des Halbleiterkörpers 10 handeln. Der Halbleiterkörper 10 ist dann auf den Träger 14 epitaktisch aufgewachsen. Ferner kann es sich beim Träger 14 um ein Trägerelement handeln, auf das der Halbleiterkörper 10 nachträglich, das heißt, nach Abschluss des Wachstums des Halbleiterkörpers 10, aufgebracht worden ist.

Im letzteren Fall handelt es sich bei dem optoelektronischen Halbleiterchip um einen so genannten Dünnfilmchip.

Der Träger 14 des Halbleiterbauelements kann dann, verglichen mit einem Aufwachssubstrat, relativ frei gewählt werden. Bevorzugt wird ein Träger 14 gewählt, der hinsichtlich seines Temperaturausdehnungskoeffizienten besonders gut an die strahlungserzeugende Epitaxieschichtenfolge 12 angepasst ist. Weiter kann der Träger 14 ein Material enthalten, das besonders gut Wärme leitend ist. Auf diese Weise wird die im Betrieb erzeugte Wärme besonders effizient an einen weiteren Träger - etwa eine Leiterplatte - abgeführt.

Dünnfilmhalbleiterbauelemente zeichnen sich ferner bevorzugt durch zumindest eines der folgenden Merkmale aus:
- An einer zum Träger 14 hingewandten ersten Hauptfläche der strahlungserzeugenden Epitaxieschichtenfolge 12 ist eine reflektierende Schicht oder Schichtenfolge aufgebracht oder ausgebildet, die zumindest einen Teil der in der Epitaxieschichtenfolge 12 erzeugten elektromagnetischen Strahlung in diese zurückreflektiert.
- Die Epitaxieschichtenfolge 12 weist bevorzugt eine Dicke von maximal 20 µm, besonders bevorzugt von maximal 10 µm auf.
- Weiter enthält der Halbleiterkörper 10 bevorzugt mindestens eine Halbleiterschicht mit zumindest einer Fläche, die eine Durchmischungsstruktur aufweist. Im Idealfall führt diese Durchmischungsstruktur zu einer annähernd ergodischen Verteilung des Lichts.

Ein Grundprinzip eines Dünnfilmleuchtdiodenchips ist beispielsweise in der Druckschrift I. Schnitzer at al., Appl. Phys. Lett. 63(16), 18. Oktober 1993, Seiten 2174 bis 2176 beschrieben.

Der Halbleiterkörper 10 weist weiter bevorzugt eine Strahlungsdurchtrittsfläche 10a auf, durch die ein Großteil der vom optoelektronischen Halbleiterchip zum Beispiel emittierten elektromagnetischen Strahlung ausgekoppelt wird. Besonders bevorzugt tritt die gesamte vom optoelektronischen Halbleiterbauelement emittierte Strahlung durch die Strahlungsdurchtrittsfläche 10a aus. Die Strahlungsdurchtrittsfläche 10a ist beispielsweise durch einen Teil der Oberfläche des Halbleiterkörpers 10 gebildet. Bevorzugt ist die Strahlungsdurchtrittsfläche 10a durch eine Hauptfläche des Halbleiterkörpers 10 gegeben, die beispielsweise parallel zu einer Epitaxieschichtenfolge 12 des Halbleiterkörpers 10 angeordnet ist, welche geeignet ist, elektromagnetische Strahlung zu erzeugen.

Der Halbleiterkörper 10 kann im Übrigen weitere nicht gezeigte Schichten umfassen. Zum Beispiel kann der Halbleiterkörper 10 Pufferschichten zur Anpassung von Gitterunterschieden zwischen einer oder mehreren der beschriebenen Schichten umfassen.

Auf der dem Halbleiterkörper abgewandten Oberfläche des Trägers 14 ist bevorzugt eine Kontaktschicht 15 aufgebracht. Bei der Kontaktschicht 15 handelt es sich beispielsweise um eine Kontaktmetallisierung. Über die Kontaktmetallisierung kann das optoelektronische Halbleiterbauelement beispielsweise n-seitig kontaktierbar sein.

Beim in Verbindung mit Figur 1A erläuterten ersten Ausführungsbeispiel des Verfahrens zur Herstellung eines optoelektronischen Halbleiterbauelements wird zunächst eine dünne Metallschicht 1 auf die Strahlungsdurchtrittsfläche 10a des Halbleiterkörpers 10 aufgebracht.

Die Metallschicht 1 kann zum Beispiel durch PVD- oder CVD-Beschichtungstechniken bei einer Temperatur von vorzugsweise zwischen 150 Grad Celsius und 350 Grad Celsius aufgebracht werden. Dabei sind folgende Beschichtungsverfahren bevorzugt: Sputtern, Magnetron-Sputtern, DC-Sputtern, Elektronenstrahl-Verdampfen.

Die Dicke d1 der Metallschicht 1 beträgt bevorzugt zwischen 0,2 und 3,0 Nanometer, besonders bevorzugt zwischen 0,3 und 2,0 Nanometer. Die Dicke dl ist dabei so dünn gewählt, dass die Metallschicht 1 für einen Großteil der im Betrieb des optoelektronischen Halbleiterbauelements beispielsweise erzeugten elektromagnetischen Strahlung transparent ist. Bevorzugt enthält die Metallschicht 1 eines der folgenden Metalle oder besteht aus einem der folgenden Metalle: Indium, Zinn, Indiumzinn, Zink, Cadmium, Titan. Im beschriebenen Ausführungsbeispiel des Verfahrens besteht die Metallschicht 1 aus Zink oder aus einer Goldzinklegierung.

In Verbindung mit 1B ist ein weiterer Verfahrensschritt beschrieben. In diesem Verfahrensschritt wird eine Metalloxidschicht 2 auf die Metallschicht 1 aufgebracht.

Die Metalloxidschicht 2 kann zum Beispiel durch PVD oder CVD Beschichtungstechniken aufgebracht werden. Dabei sind folgende Beschichtungsverfahren bevorzugt: Sputtern, Magnetron-Sputtern, DC-Sputtern, Elektronenstrahl-Verdampfen.

Die Metalloxidschicht 2 weist bevorzugt eine Dicke von wenigstens 50 Nanometer, besonders bevorzugt von wenigstens 200 Nanometern auf. Sie enthält ein transparentes, elektrisch leitfähiges Metalloxid (TCO). Dabei enthält die Metalloxidschicht ein Oxid zumindest eines Metalls der Metallschicht 1 oder besteht aus diesem Oxid. Bevorzugt enthält oder besteht die Metalloxidschicht 2 aus einem der folgenden Metalloxide: ZnO, SnO₂, In₂O₃, Zn₂SnO₄, CdSnO₃, ZnSnO₃, MgIn₂O₄, GaInO₃ , Zn₂In₂O₅, In₄Sn₃O₁₂ oder Mischungen.

Handelt es sich bei der Metallschicht 1 beispielsweise um eine Zink- oder eine Gold-Zink-Schicht, so enthält die Metalloxidschicht vorzugsweise ein Zinkoxid oder ein mit Aluminium dotiertes p-leitendes Zinkoxid (ZnO:Al).

In Verbindung mit 1C ist ein weiterer Schritt des Verfahrens gemäß einem ersten Ausführungsbeispiel zur Herstellung eines optoelektronischen Halbleiterbauelements beschrieben. Nach dem Aufbringen der Metalloxidschicht 2 auf die Metallschicht 1 wird die aufgebrachte Schichtenfolge vorzugsweise thermisch behandelt. Die Schichtenfolge wird dazu auf Temperaturen zwischen 30 Grad Celsius und 1.000 Grad Celsius, bevorzugt zwischen.200 Grad Celsius und 600 Grad Celsius, besonders bevorzugt zwischen 300 Grad Celsius und 500 Grad Celsius aufgeheizt. Dadurch reagiert das Material der Metallschicht 1 und der Metalloxidschicht 2 zu einer Stromaufweitungsschicht 3 mit der Dicke d durch.

Die Schichtfolge kann zum Beispiel in einem Brennofen mit 0 bis 20% Partialdruck Sauerstoff, besonders bevorzugt 2 bis 10 % Partialdruck Sauerstoff erhitzt werden. Beim Erhitzen der Schichtenfolge kann auch eine RTA (rapid thermal annealing) Technik zum Einsatz kommen. Ferner ist es möglich, dass die Schichtenfolge unter N₂, N₂/Ar oder N₂/H₂ Atmosphäre erhitzt wird. Bevorzugt wird die Schichtfolge für Zeiten zwischen einer und fünf Minuten erhitzt.

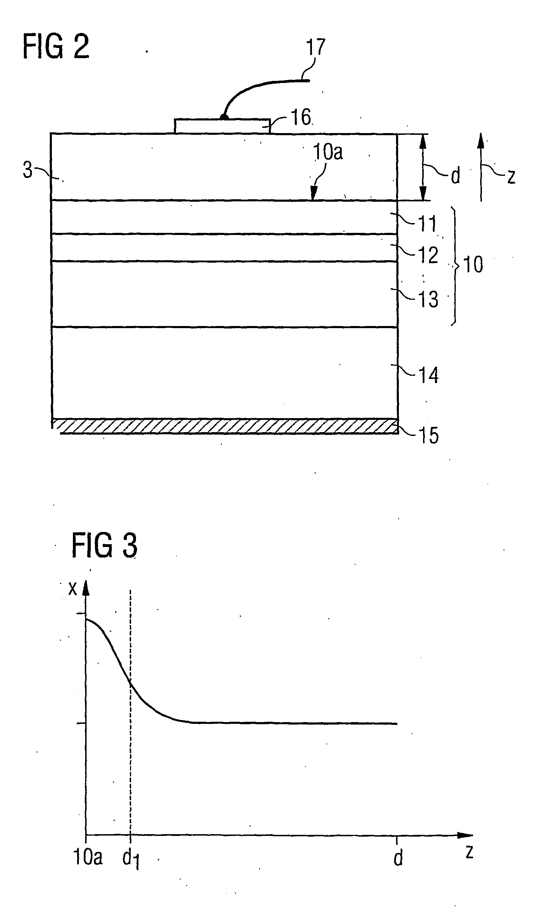

Figur 2 zeigt ein optoelektronisches Halbleiterbauelement, das beispielsweise mittels des in Verbindung mit den Figuren 1A bis 1C beschriebenen Verfahrens hergestellt ist. Auf die Stromaufweitungsschicht 3 ist dort eine Drahtanschlussstelle 16 (Bondpad) aufgebracht, an der ein Anschlussdraht 17 angeschlossen ist. Mittels des Anschlussdrahtes 17 kann elektrischer Strom über die Drahtanschlussstelle 16 in die Stromaufweitungsschicht 3 eingeprägt werden. Dort wird der Strom in Richtungen parallel zur Strahlungsdurchtrittsfläche 10a - also in Querrichtung - derart verteilt, dass eine möglichst gleichmäßige Verteilung des eingeprägten Stroms über die gesamte Strahlungsdurchtrittsfläche 10a erfolgt. Auf diese Weise ist eine besonders gleichmäßige Bestromung der aktiven Zone 12 des Halbleiterkörpers 10 möglich.

In der Stromaufweitungsschicht 3 stellt sich beispielsweise durch das in Verbindung mit Figur 1C beschriebene thermische Behandeln ein Profil der Metallkonzentration x ein, wie es in Figur 3 schematisch dargestellt ist. In Nähe der Strahlungsdurchtrittsfläche 10a ist die Metallkonzentration dabei besonders hoch und kann beispielsweise bis zu 100 Prozent betragen. Dabei handelt es sich zum Beispiel um eine mittlere Metallkonzentration x, wobei die Metallkonzentration abhängig vom Abstand z von der Strahlungsdurchtrittsfläche 10a jeweils über die zur Strahlungsdurchtrittsfläche 10a parallele Fläche der Stromaufweitungsschicht 3 gemittelt ist.

Beispielsweise infolge des thermischen Behandelns gelangt Metall zum Beispiel mittels Diffusion von der Metallschicht 1 in die Metalloxidschicht 2. Es resultiert ein quasikontinuierlicher Verlauf der Metallkonzentration x, wobei die Metallkonzentration x mit wachsendem Abstand von der Strahlungsdurchtrittsfläche 10a in Richtung z kontinuierlich abnimmt. Das heißt, die Metallkonzentration x fällt beim Abstand dl, der der Schichtdicke der ursprünglichen Metallschicht 1 entspricht, nicht plötzlich sprunghaft ab, sondern der Übergang zwischen ursprünglicher Metallschicht 1 und Metalloxidschicht 2 ist hinsichtlich der Metallkonzentration x fließend. Die Steilheit des Abfalls der Metallkonzentration x und die Metallkonzentration in Abhängigkeit vom Abstand von der Strahlungsdurchtrittsfläche 10a ist dabei unter anderem durch die Temperatur bei der thermischen Behandlung der Schichten 1, 2 sowie durch die Dauer der thermischen Behandlung einstellbar.

Das sich in der Stromaufweitungsschicht 3 einstellende Profil der Metallkonzentration hängt dabei von den verwendeten Materialien und der gewünschten Leitfähigkeit der Stromaufweitungsschicht 3 ab.

Besonders genau ist der Verlauf der Metallkonzentration x in der Stromaufweitungsschicht 3 mittels eines zweiten Ausführungsbeispiels des Verfahrens zur Herstellung eines optoelektronischen Halbleiterbauelements einstellbar. Bei diesem Verfahren wird das Metall unter Sauerstoffzufuhr, das heißt, beispielsweise in einer Sauerstoffatmosphäre aufgebracht. Dabei wird der Sauerstofffluss während des Beschichtungsvorgangs variiert. Beispielsweise wird der Sauerstofffluss während des Beschichtungsvorgangs kontinuierlich erhöht bis ein gewünschter, vorgebbarer Sauerstoffgehalt in der Metalloxidschicht 2 erreicht ist. Das heißt, bei diesem Verfahren wird nicht zunächst eine reine Metallschicht 1 und dann eine reine Metalloxidschicht 2 aufgebracht, sondern es wird eine Metalloxidschicht aufgebracht, in der der Sauerstoffgehalt während des Beschichtungsvorgangs kontrolliert variiert wird. Dabei kann zu Beginn des Verfahrens eine Metallschicht aufgebracht werden, bei der der Sauerstoffgehalt Null oder annähernd Null ist. Auf diese Weise entsteht eine Stromaufweitungsschicht 3, bei der das Profil der Metallkonzentration x als Funktion des Abstands von der Strahlungsdurchtrittsfläche 10a mithilfe des Sauerstoffflusses einstellbar ist.

Beispielsweise wird eine ZnO-Schicht durch reaktives Sputtern von Zink aus einem Zink-Target auf den Halbleiterkörper 10 aufgebracht, wobei der Sauerstofffluss während des Sputtervorgangs erhöht wird.

## Patentansprüche

1. Optoelektronisches Halbleiterbauelement, aufweisend
- einen Halbleiterkörper (10), und
- eine Stromaufweitungsschicht (3), die zumindest stellenweise auf den Halbleiterkörper (10) aufgebracht ist, bei dem
- die Stromaufweitungsschicht (3) ein Metall (1) enthält, das in der Stromaufweitungsschicht ein transparentes, elektrisch leitfähiges Metalloxid (2) bildet, und
- die Konzentration (x) des Metalls (1), welches das transparente, elektrisch leitfähige Metalloxid (2) bildet, von der dem Halbleiterkörper (10) zugewandten Seite zur dem Halbleiterkörper (10) abgewandten Seite der Stromaufweitungsschicht (3) hin mit wachsendem Abstand vom Halbleiterkörper (10) abnimmt,
**dadurch gekennzeichnet, dass**
- die Konzentration von Sauerstoff im Metalloxid entsprechend einer Abnahme der konzentration des Metalls (1) mit wachsendem Abstand vom Halbleiterkörper (10) zunimmt und
- die Stromaufweitungsschicht (3) auf ihrer dem Halbleiterkörper (10) abgewandten Seite aus dem Metalloxid besteht.

2. Optoelektronisches Halbleiterbauelement gemäß dem vorherigen Anspruch,
bei dem die Metallkonzentration in der Stromaufweitungsschicht (3) kontinuierlich abnimmt.

3. Optoelektronisches Halbleiterbauelement gemäß zumindest einem der vorherigen Ansprüche,
bei dem die Stromaufweitungsschicht (3) stellenweise eine Metalloxid stöchiometrischer Zusammensetzung umfasst.

4. Optoelektronisches Halbleiterbauelement gemäß zumindest einem der vorherigen Ansprüche,
bei dem die Stromaufweitungsschicht (3) Oxide zumindest eines der folgenden Metalle umfasst: Indium, Zinn, Indium-Zinn, Zink, Cadmium, Titan.

5. Optoelektronisches Halbleiterbauelement gemäß zumindest einem der vorherigen Ansprüche,
bei dem die Stromaufweitungsschicht (3) auf eine Strahlungsdurchtrittsfläche (10a) des Halbleiterkörpers (10) aufgebracht ist.

6. Optoelektronisches Halbleiterbauelement gemäß zumindest einem der vorherigen Ansprüche,
bei dem das optoelektronische Halbleiterbauelement zumindest eines der folgenden Bauelemente umfasst: Photodiodenchip, Leuchtdiodenchip, Laserdiodenchip.

7. Verfahren der Herstellung eines optoelektronischen Bauelements gemäß zumindest einem der vorherigen Ansprüche, aufweisen die folgenden Schritte:
a) Aufbringen einer Schicht umfassend ein Metall (1) auf dem Halbleiterkörper (10),
b) Aufbringen einer Schicht (2), umfassend ein Oxid des Metalls auf die Metallschicht (1), und
c) thermisches Behandeln der aufgebrachten Schichtenfolge zur Erzeugung der Stromaufweitungsschicht (3).

8. Verfahren gemäß dem vorherigen Anspruch,
wobei die Dicke der Metallschicht (1) in Schritt a) wenigstens 0,3 nm und höchstens 2,0 nm beträgt.

9. Verfahren gemäß zumindest einem der vorherigen Ansprüche 7 oder 8,
wobei in Schritt c) die aufgebrachte Schichtenfolge unter einem Partialdruck von Sauerstoff zwischen wenigstens 2% und höchstens 10% erhitzt wird.

10. Verfahren gemäß zumindest einem der vorherigen Ansprüche 7 bis 9,
wobei in Schritt c) die aufgebrachte Schichtenfolge auf Temperaturen zwischen wenigstens 300 Grad Celsius und höchstens 500 Grad Celsius erhitzt wird.

11. Verfahren gemäß zumindest einem der vorherigen Ansprüche 7 bis 10,
wobei in Schritt c) die aufgebrachte Schichtenfolge für Zeiten zwischen wenigstens einer und höchstens fünf Minuten erhitzt wird.

12. Verfahren gemäß zumindest einem der vorherigen Ansprüche 7 bis 11,
wobei die aufgebrachte Schichtenfolge unter N₂, N₂/Ar oder N₂/H₂ Atmosphäre erhitzt wird.

13. Verfahren der Herstellung eines optoelektronischen Halbleiterbauelements gemäß zumindest einem der Ansprüche 1 bis 6,
wobei zur Erzeugung der Stromaufweitungsschicht (3) ein Metall (1) auf den Halbleiterkörper (10) aufgebracht und im Verlauf des Aufbringungsvorgangs mit zunehmender Rate oxidiert wird.

14. Verfahren nach dem vorherigen Anspruch,
wobei die Stromaufweitungsschicht (3) mittels reaktiven Sputterns des Metalls gebildet wird.

15. Verfahren nach Anspruch 13 oder Anspruch 14,
wobei die Rate während des Aufbringvorgangs kontinuierlich erhöht wird.

## Claims

1. Optoelectronic semiconductor component comprising
- a semiconductor body (10) and
- a current spreading layer (3), which is applied to the semiconductor body (10) at least in places,
wherein
- the current spreading layer (3) contains a metal (1) that forms a transparent electrically conductive metal oxide (2) in the current spreading layer, and
- the concentration (x) of the metal (1) that forms the transparent electrically conductive metal oxide (2) decreases with increasing distance from the semiconductor body (10), from that side of the current spreading layer (3) which faces the semiconductor body (10) toward that side of said current spreading layer which is remote from the semiconductor body (10),
**characterized in that**
- the concentration of oxygen in the metal oxide increases in accordance with a decrease in the concentration of the metal (1) with increasing distance from the semiconductor body (10), and
- the current spreading layer (3) is composed of the metal oxide on its side remote from the semiconductor body (10).

2. Optoelectronic semiconductor component according to the preceding claim,
wherein the metal concentration decreases continuously in the current spreading layer (3).

3. Optoelectronic semiconductor component according to at least one of the preceding claims,
wherein the current spreading layer (3) comprises in places a metal oxide having a stoichiometric composition.

4. Optoelectronic semiconductor component according to at least one of the preceding claims,
wherein the current spreading layer (3) comprises oxides of at least one of the following metals: indium, tin, indium-tin, zinc, cadmium, titanium.

5. Optoelectronic semiconductor component according to at least one of the preceding claims,
wherein the current spreading layer (3) is applied to a radiation passage area (10a) of the semiconductor body (10).

6. Optoelectronic semiconductor component according to at least one of the preceding claims,
wherein the optoelectronic semiconductor component comprises at least one of the following components: photodiode chip, light emitting diode chip, laser diode chip.

7. Method of producing an optoelectronic component according to at least one of the preceding claims, comprising the following steps:
a) applying a layer comprising a metal (1) to the semiconductor body (10),
b) applying a layer (2) comprising an oxide of the metal to the metal layer (1), and
c) thermal treatment of the applied layer sequence in order to produce the current spreading layer (3).

8. Method according to the preceding claim,
wherein the thickness of the metal layer (1) in step a) is at least 0.3 nm and at most 2.0 nm.

9. Method according to at least one of the preceding Claims 7 or 8,
wherein in step c) the applied layer sequence is heated under an oxygen partial pressure of between at least 2% and at most 10%.

10. Method according to at least one of the preceding Claims 7 to 9,
wherein in step c) the applied layer sequence is heated to temperatures of between at lest 300 degrees Celsius and at most 500 degrees Celsius.

11. Method according to at least one of the preceding Claims 7 to 10,
wherein in step c) the applied layer sequence is heated for times of between at least one and at most five minutes.

12. Method according to at least one of the preceding Claims 7 to 11,
wherein the applied layer sequence is heated under an N₂, N₂/Ar or N₂/H₂ atmosphere.

13. Method of producing an optoelectronic semiconductor component according to at least one of Claims 1 to 6,
wherein in order to produce the current spreading layer (3), a metal (1) is applied to the semiconductor body (10) and is oxidized at an increasing rate in the course of the application process.

14. Method according to the preceding claim,
wherein the current spreading layer (3) is formed by means of reactive sputtering of the metal.

15. Method according to Claim 13 or Claim 14,
wherein the rate is continuously increased during the application process.

## Revendications

1. Composant semiconducteur optoélectronique qui présente
- un corps semiconducteur (10) et
- une couche d'élargissement du courant (3) qui est appliquée au moins par endroits sur le corps semiconducteur (10), dans lequel
- la couche d'élargissement du courant (3) contient un métal (1) qui forme dans la couche d'élargissement du courant un oxyde métallique (2) électriquement conducteur transparent, et
- la concentration (x) du métal (1), qui forme l'oxyde métallique (2) électriquement conducteur transparent, diminue depuis le côté de la couche d'élargissement du courant (3) faisant face au corps semiconducteur (10) vers le côté opposé au corps semiconducteur (10) à mesure que l'espacement du corps semiconducteur (10) augmente,
**caractérisé en ce que**
- la concentration d'oxygène dans l'oxyde métallique augmente en fonction d'une diminution de la concentration du métal (1) à mesure que l'espacement du corps semiconducteur (10) augmente et
- la couche d'élargissement du courant (3) se compose de l'oxyde métallique sur son côté à l'opposé du corps semiconducteur (10).

2. Composant semiconducteur optoélectronique selon la revendication précédente,
dans lequel la concentration de métal dans la couche d'élargissement du courant (3) diminue continuellement.

3. Composant semiconducteur optoélectronique selon au moins l'une des revendications précédentes,
dans lequel la couche d'élargissement du courant (3) comprend par endroits une composition stoechiométrique d'oxyde métallique.

4. Composant semiconducteur optoélectronique selon au moins l'une des revendications précédentes,
dans lequel la couche d'élargissement du courant (3) comprend des oxydes d'au moins l'un des métaux suivants : indium, étain, indium-étain, zinc, cadmium, titane.

5. Composant semiconducteur optoélectronique selon au moins l'une des revendications précédentes,
dans lequel la couche d'élargissement du courant (3) est appliquée sur une surface de traversée de rayonnement (10a) du corps semiconducteur (10).

6. Composant semiconducteur optoélectronique selon au moins l'une des revendications précédentes,
dans lequel le composant semiconducteur optoélectronique comprend au moins l'un des composants suivants : puce de photodiode, puce de diode électroluminescente, puce de diode laser.

7. Procédé de fabrication d'un composant optoélectronique selon au moins l'une des revendications précédentes, présentant les étapes suivantes :
a) Application sur le corps semiconducteur (10) d'une couche contenant un métal (1),
b) Application sur la couche métallique (1) d'une couche (2) contenant un oxyde du métal, et
c) Traitement thermique de la séquence de couches appliquées en vue de produire la couche d'élargissement du courant (3).

8. Procédé selon la revendication précédente, l'épaisseur de la couche métallique (1) dans l'étape a) étant d'au moins 0,3 nm et d'au plus 2,0 nm.

9. Procédé selon au moins l'une des revendications précédentes 7 ou 8, la séquence de couches appliquées étant chauffée dans l'étape c) sous une pression partielle d'oxygène entre au moins 2 % et au plus 10 %.

10. Procédé selon au moins l'une des revendications précédentes 7 à 9, la séquence de couches appliquées étant chauffée dans l'étape c) à des températures comprises entre au moins 300 degrés Celsius et au plus 500 degrés Celsius.

11. Procédé selon au moins l'une des revendications précédentes 7 à 10, la séquence de couches appliquées étant chauffée dans l'étape c) pendant des durées comprises entre au moins une minute et au plus cinq minutes.

12. Procédé selon au moins l'une des revendications précédentes 7 à 11, la séquence de couches appliquées étant chauffée sous une atmosphère de N₂, N₂/Ar ou N₂/H₂.

13. Procédé de fabrication d'un composant semiconducteur optoélectronique selon au moins l'une des revendications 1 à 6,
un métal (1) étant appliqué sur le corps semiconducteur (10) pour produire la couche d'élargissement du courant (3) et l'oxydation étant réalisée avec une vitesse croissante au cours de l'opération d'application.

14. Procédé selon la revendication précédente, la couche d'élargissement du courant (3) étant formée par pulvérisation cathodique réactive du métal.

15. Procédé selon la revendication 13 ou la revendication 14, la vitesse augmentant continuellement pendant l'opération d'application.
